# EUROPEAN PATENT APPLICATION

(11) **EP 4 542 797 A1**
(43) Date of publication of application: **23.04.2025**
(21) Application number: 24205475.7
(22) Date of filing: 09.10.2024
(51) Int. Cl.: H01S 5/02, H01S 5/10, H01S 5/50, H01S 5/12, H01S 5/026, H01S 5/22

(54) **HETEROGENEOUSLY INTEGRATED DFB LASER WITH SINGLE LATERAL MODE**

(30) Priority: 13.10.2023 US 202318379812
(71) Applicant: OpenLight Photonics, Inc., Goleta, CA 93117 (US)
(72) Inventor: NORBERG, Erik Johan, Santa Barbara (US); PARKER, John, Goleta, 93117 (US); SHI, Hanxing, Sunnyvale (US); YUN, Han, Santa Clara (US)
(74) Representative: D Young & Co LLP

(57) **Abstract**

A DFB laser includes a III-V semiconductor structure having a laser active region and a grating etched on a bonding surface to provide optical feedback to generate output light. The DFB laser includes a silicon structure having a silicon waveguide configured to receive the output light from a first end of the laser active region. The bonding surface of the III-V semiconductor structure is bonded to a surface of the silicon structure. The silicon structure includes a DFB region having surfaces defining at least two laterally separated silicon portions extending longitudinally and overlapping, with respect to a lamination direction, two lobes of a second lateral mode of the output light in the laser active region, to suppress lasing of a second order mode of the output light.

## Description

### TECHNICAL FIELD

The present disclosure generally relates to optical devices and more particularly to optical sources.

### BACKGROUND

A tunable laser is a laser in which the wavelength of operation can be altered in a controlled manner using filters to output the target wavelength. The tuning values vary over temperature and can require complex control systems to keep the tunable laser aligned during operation. A fixed laser is simpler to control; however, it is difficult to implement fixed lasers in photonic integrated circuits (PICs) due to calibration issues, power issues, and process control issues, such as process variation exhibited in modern PIC fabrication techniques.

### SUMMARY

Particular aspects are set out in the appended independent claims. Various optional embodiments are set out in the dependent claims.

### BRIEF DESCRIPTION OF THE SEVERAL VIEWS OF THE DRAWINGS

The following description includes discussion of figures having illustrations given by way of example of implementations of embodiments of the disclosure. The drawings should be understood by way of example, and not by way of limitation. As used herein, references to one or more "examples" or "embodiments" are to be understood as describing a particular feature, structure, or characteristic included in at least one implementation of the inventive subject matter, in at least some circumstances. Thus, phrases such as "in one example", "in some examples", "in some embodiments", "in one embodiment" or "in an alternate embodiment" appearing herein describe various embodiments and implementations of the inventive subject matter, and do not necessarily all refer to the same embodiment. However, they are also not necessarily mutually exclusive. To easily identify the discussion of any particular element or act, the most significant digit or digits in a reference number may refer to the figure ("FIG.") number in which that element or act is first introduced.
FIG. 1 illustrates a top-down plan view of a single-waveguide design for a DFB laser architecture, in accordance with some examples.
FIG. 2 illustrates a front cross-sectional view of the single-waveguide design for a DFB laser architecture through line A-A of FIG. 1, in accordance with some examples.
FIG. 3 illustrates a simplified side view of an example optical-electrical device incorporating a DFB laser, in accordance with some examples.
FIG. 4 illustrates a side view of the single-waveguide design for a DFB laser architecture of FIG. 1 showing light propagation, in accordance with some examples.
FIG. 5 illustrates a side view of an asymmetric version of the single-waveguide design for a DFB laser architecture of FIG. 1 showing light propagation, in accordance with some examples.
FIG. 6 illustrates a top-down plan view of a two-rib design for a DFB laser architecture, in accordance with some examples.
FIG. 7 illustrates a front cross-sectional view of the two-rib design for a DFB laser architecture through line A-A of FIG. 6, in accordance with some examples.
FIG. 8 illustrates a top-down plan view of a three-rib design for a DFB laser architecture, in accordance with some examples.
FIG. 9 illustrates a top-down plan view of a narrow trench design for a DFB laser architecture, in accordance with some examples.
FIG. 10 illustrates a front cross-sectional view of the non-absorber region of the narrow trench design for a DFB laser architecture through line A-A of FIG. 9, in accordance with some examples.
FIG. 11 illustrates a front cross-sectional view of the narrow trench absorber region of the narrow trench design for a DFB laser architecture through line B-B of FIG. 9, in accordance with some examples.
FIG. 12 illustrates a flowchart showing operations of a method of manufacturing a DFB laser, in accordance with some examples.

Descriptions of certain details and implementations follow, including a description of the figures, which may depict some or all of the embodiments described below, as well as discussing other potential embodiments or implementations of the inventive concepts presented herein. An overview of embodiments of the disclosure is provided below, followed by a more detailed description with reference to the drawings.

### DETAILED DESCRIPTION

In the following description, for the purposes of explanation, numerous specific details are set forth in order to provide an understanding of various embodiments of the inventive subject matter. It will be evident, however, to those skilled in the art, that embodiments of the inventive subject matter may be practiced without these specific details. In general, well-known instruction instances, structures, and techniques are not necessarily shown in detail.

As described above, a PIC can implement a tunable laser, in which the laser can be tuned to output light of different wavelengths. In some examples, the tunable laser can implement one or more optical filters to obtain a target wavelength of the optical system. The tuning values can vary over different temperatures, which can necessitate fast control loops that are integrated close to the PIC to ensure the tuners are aligned during operation.

In contrast, a fixed wavelength silicon photonic laser with distributed feedback (DFB) can be configured in the PIC such that no wavelength calibration is required, which can reduce calibration cost and can further allow faster module bootup time, thereby reducing power consumption and simplifying laser control. A DFB laser can be implemented as an integrated PIC laser in which the laser resonator comprises of a periodic structure in the laser gain medium, which functions as a distributed Bragg reflector in the wavelength range of laser action.

In addition to fixed-wavelength lasers, DFB technology can be combined with other laser designs including high-power lasers, isolator-free lasers, and fast-tuning lasers.

Conventional non-silicon photonic DFB lasers, which have been widely used for decades, use anti-reflectivity (AR) and high-reflectivity (HR) coatings on the facets of the laser structure to achieve higher power efficiency. However, these facet coatings are associated with laser reliability issues, such as Catastrophic Optical Mirror Damage (COMD).

Designs for a silicon photonic DFB laser, with a grating built in to a III-V epitaxial structure and lasing output light coupled into silicon by evanescent coupling, are described in United States Patent Application No. 17/736,490, filed May 4, 2022 and naming as inventors Antonio Labaro, Erik Norberg, Hanxing Shi, and Han Yun (hereinafter the "original III-V DFB laser application"), which is hereby incorporated by reference in its entirety. Some designs described therein utilize DFB epitaxial growth and the benefits of heterogeneous integration to avoid facet coatings, potentially achieving similar power efficiency to conventional non-silicon photonic DFB lasers.

Examples described herein include techniques to achieve a single lateral mode in a heterogeneously integrated DFB laser. Single mode operation may be beneficial for telecommunications, data communication, and many other applications such as Light Detection and Ranging (LiDAR). Without the ability to achieve single mode operation, a DFB laser may generate higher-order modes along a lateral direction in the laser cavity, which cannot generally be coupled into the silicon waveguide and therefore tend to decrease the efficiency of the laser.

Accordingly, examples described herein may attempt to address one or more technical problems related to achieving a single lateral mode in a heterogeneously integrated laser, such as a DFB laser, a discrete mode (DM) laser, a distributed Bragg reflector (DBR) laser, an optical amplifier, an optical modulator, or a tunable laser which requires single mode control along a lateral direction.

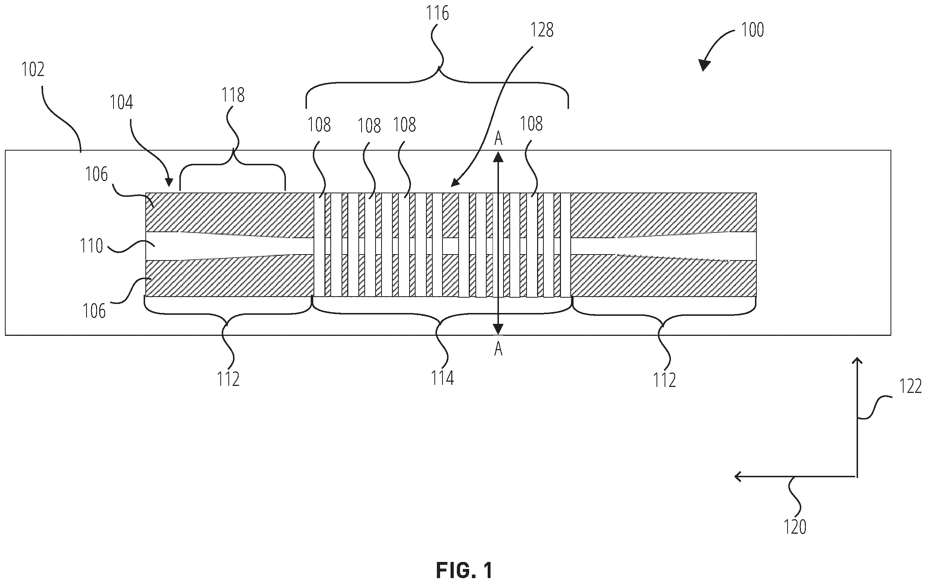

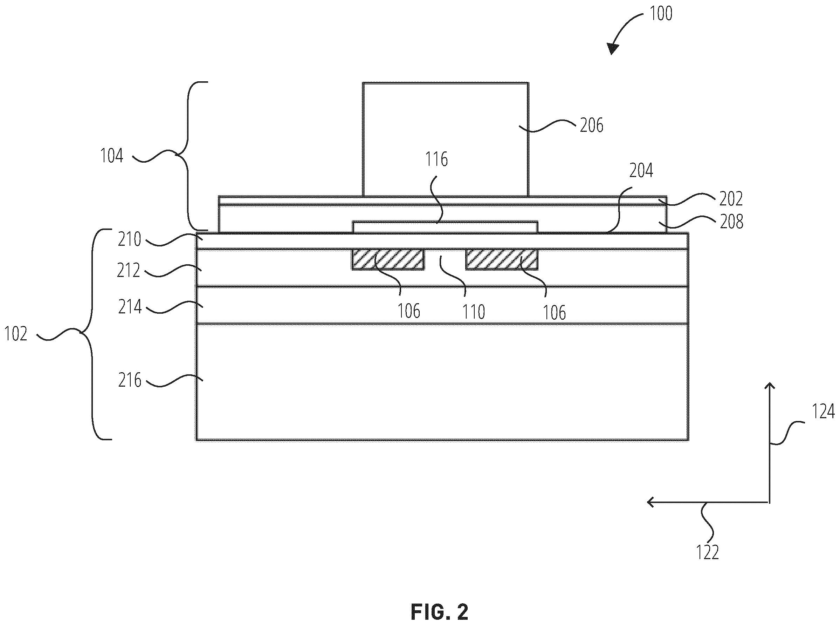

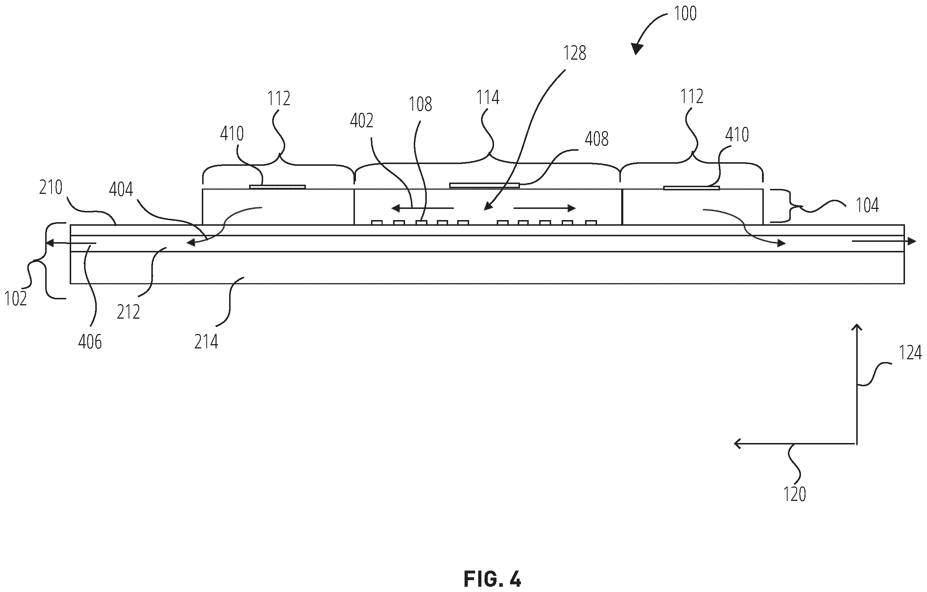

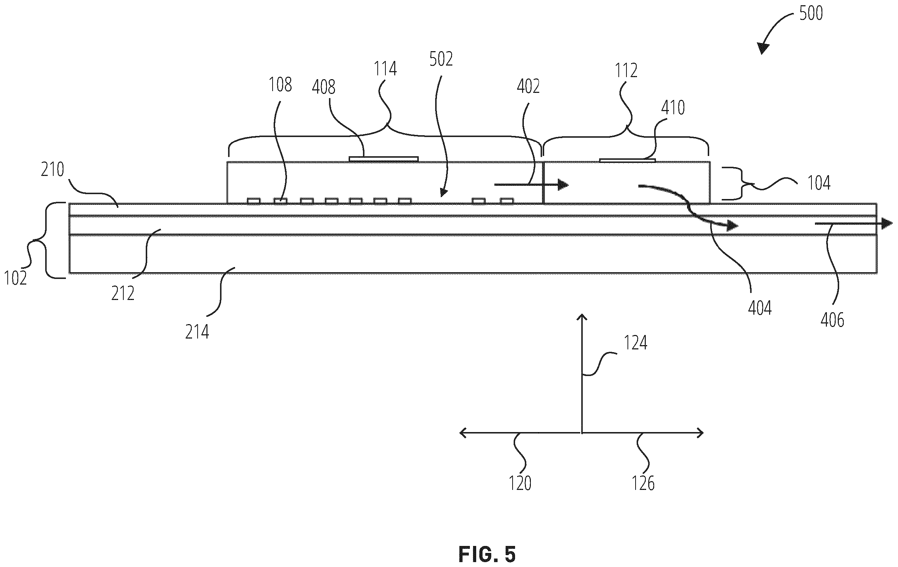

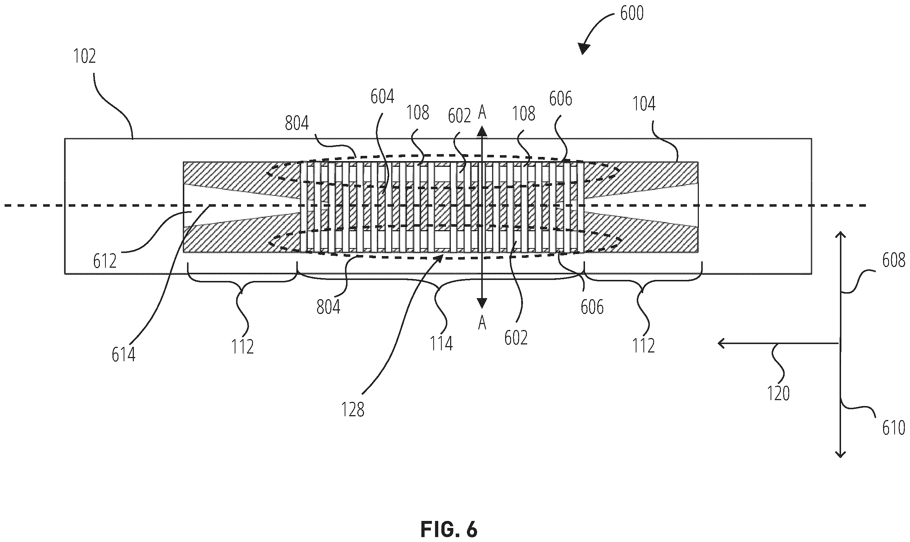

FIG. 1 shows a top-down view of a single-waveguide design 100 for a DFB laser architecture. The single-waveguide design 100 is an example of a DFB laser design according to the disclosure of the original III-V DFB laser application cited above. FIG. 1 through FIG. 5 herein illustrate principles and techniques for DFB lasers manufactured in a III-V structure of a silicon photonic device, as previously disclosed by the original III-V DFB laser application. FIG. 6 through FIG. 12 herein then illustrate techniques for techniques to achieve a single lateral mode in a heterogeneously integrated DFB laser. It will be appreciated that the examples of FIG. 6 through FIG. 12 may operate according to similar principles to the single-waveguide design 100 of FIG. 1 through FIG. 5, such as the general propagation of light shown in FIG. 4 and FIG. 5, and the fabrication techniques described with reference to FIG. 1 and FIG. 2.

The view of FIG. 1 is along a Z dimension, defining a lamination direction for stacking and/or epitaxial growth of the DFB laser architecture. A longitudinal direction 120 (along an X dimension) and a lateral direction 122 (along a Y dimension), perpendicular to each other and to the lamination direction, define the visible dimensions of the illustrated device. Dimensions of devices described herein may be denoted in micrometers (um) and/or nanometers (nm).

The single-waveguide design 100 includes a III-V structure 104 (e.g., III-V semiconductor structure, III-V epi die, III-V wafer) bonded to a top side (as defined by the Z dimension) of a silicon structure 102 including a silicon waveguide. The silicon structure 102 may be a silicon wafer, such as a silicon on insulator (SOI) device, as further described below with reference to FIG. 2. The silicon waveguide defines a silicon rib 110 running down the center of the device along the longitudinal direction 120, and the silicon rib 110 extends upward (in the lamination direction, not visible in FIG. 1) to define on either side (to the lateral direction 122 and opposite the lateral direction 122) a trench 106. The trenches 106 may be filled with a gas, such as air, in some examples. In some examples, the trenches 106 are filled with a dielectric material, such as SiO2, SiN, or Al2O3.

The silicon rib 110 is effective to receive light outcoupled from the III-V structure 104. The III-V structure 104 generates the light using gain material in a laser active region (e.g., a light-emissive multiple quantum well (MQW) region) of the III-V structure 104. In some examples, the output light is generated by the laser active region (which may partially or fully overlap with the grating 116 and the DFB region 114 shown in FIG. 1) and propagates from the laser active region from the left and rights ends of the laser active region to two semiconductor optical amplifier (SOA) regions (SOA regions 112) of the III-V structure 104. The SOA regions 112 of the III-V structure 104 couple the light from the III-V structure 104 to the silicon waveguide of the silicon structure 102 via tapers in the silicon rib 110 within a taper region 118 of the silicon rib 110 formed under each of the SOA regions 112. This propagation and outcoupling of the output light generated by the laser active region are described in further detail below with reference to FIG. 4 and FIG. 5.

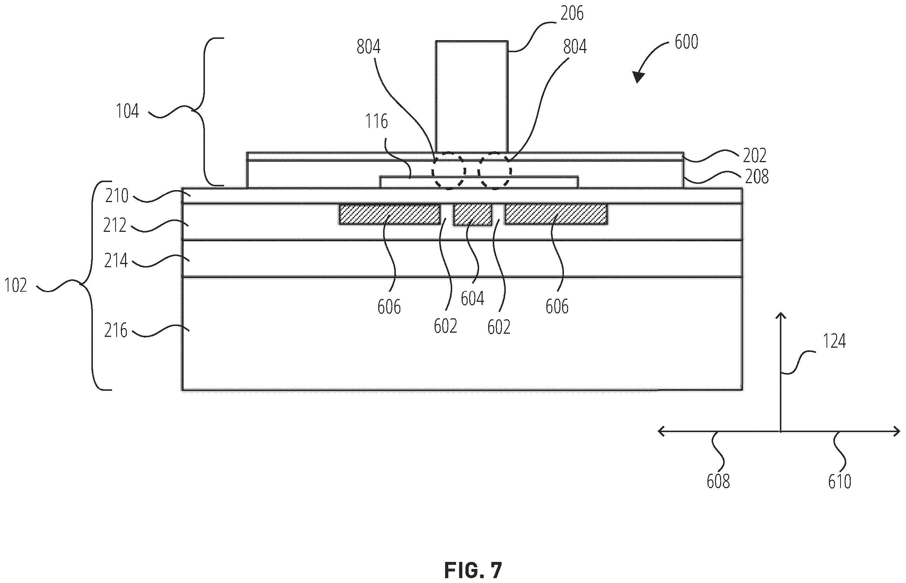

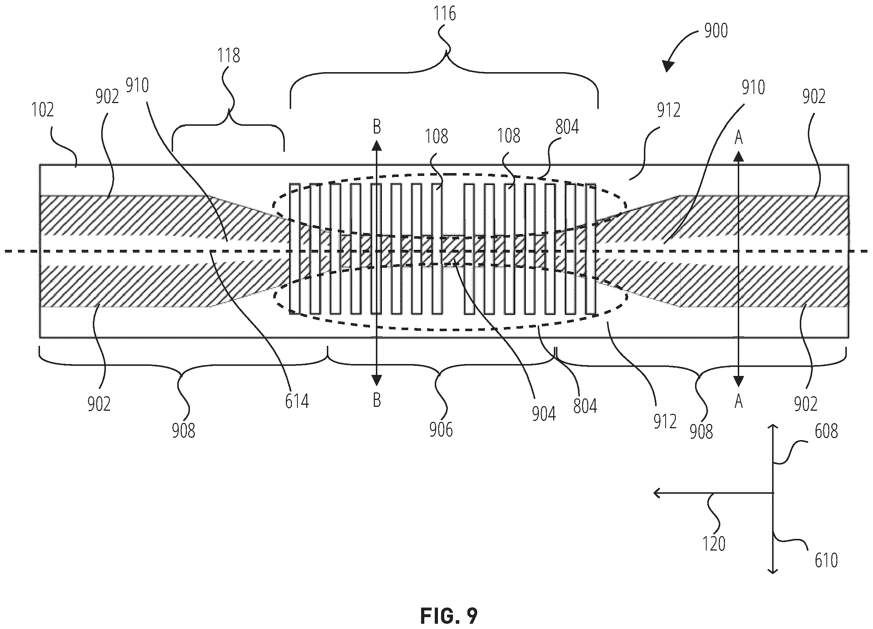

In the single-waveguide design 100, the taper regions 118 taper the silicon rib 110 to a narrow width section (e.g., taper from 2um to ~0.5um or less, such as 0.3um) that extends along the DFB region 114 to minimize coupling from the III-V structure 104 to the silicon structure 102 along that section (e.g., within the laser active region of the III-V structure 104). Minimizing outcoupling of light within the DFB region 114 keeps the output light reflecting within the III-V material so that the mode is completely distributed inside the laser active region of the III-V structure 104 in order to maximize modal gain and power efficiency. It will be appreciated that a modified version of this behavior of the single-waveguide design 100 may be exhibited by single lateral mode designs described herein, such as the two-rib design 600 shown in FIG. 6 and FIG. 7 and the narrow trench design 900 shown in FIG. 9 to FIG. 11. These designs, described below, may similarly minimize outcoupling within a central DFB region, while using different distributions of ribs and trenches defined by the silicon structure to further minimize generation of second-order and higher-order lateral modes of the output light by the laser active region.

The top-down view of FIG. 1 shows the teeth or lines of the grating 116 as grating lines 108. As described below, the grating 116 may be formed in a surface of the III-V structure 104 prior to bonding the III-V structure 104 to the silicon structure 102. The grating 116 is formed along the longitudinal direction 120 of the DFB region 114 (e.g., under the laser active region of the III-V structure 104), and terminates at the each SOA region 112, such that the mode selection of the output light from the laser active region is completed within the DFB region 114 via the grating 116 (e.g., the grating 116 provides optical feedback such that multimode light that would otherwise be generated by the gain material is instead generated as two-mode or single mode light). In some examples, the grating 116 extends outside the DFB region 114, e.g., partially into the SOA regions 112 of the III-V structure 104, to add reflectivity to the cavity or other modify the coupling of the light.

In some examples, a quarter wave shift (QWS) feature 128 is formed in a middle portion of the grating 116 (e.g., by changing the grating teeth spacing to add a peak) to generate a symmetric cavity to refine the mode selection (e.g., from two-mode light to single mode light, light at a fixed wavelength) to provide light symmetrically from each end of the DFB region 114, thereby providing a symmetric DFB laser. In some examples, such as the example shown in FIG. 5, an asymmetric DFB laser can be formed by positioning a QWS feature toward one end of the cavity of the DFB region 114. In some examples, the grating is configured as an adiabatic chirped grating or non-uniform grating, which can be configured per a given design to further tailor the mode and power fraction toward one longitudinal end of the DFB region 114. In some example embodiments, the DFB laser having the grating in the III-V structure 104 is a distributed phase delay DFB laser. In some examples that implement the symmetric DFB laser (e.g., with a middle QWS feature 128), a reflector can be integrated in the silicon waveguide to reflect half of the light from one longitudinal end port of the silicon waveguide to the other longitudinal end port in order to maximize output from the other longitudinal end port.

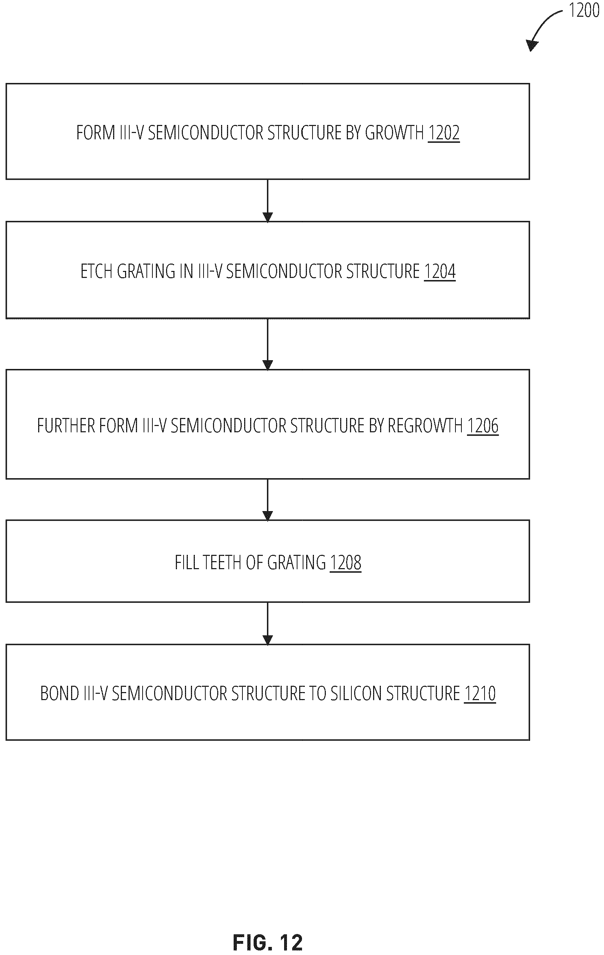

FIG. 12 below shows an example method for fabrication of a DFB laser potentially applicable to the manufacture of the single-waveguide design 100, two-rib design 600, narrow trench design 900, and other possible designs of a DFB laser architecture.

FIG. 2 illustrates a front cross-sectional view of the single-waveguide design 100 for a DFB laser architecture through line A-A of FIG. 1. It will be appreciated that the lateral dimensions of the various layers shown stacked in FIG. 2 may not align with the dimensions of the overlapping layers shown in plan view of FIG. 1 (this may also be true of the plan views of FIG. 6, FIG. 8, and FIG. 9 in relation to their respective front cross-sectional views). The layers of FIG. 2 are shown to be stacked in the lamination direction 124.

The silicon structure 102 is formed, from bottom to top with respect to the lamination direction 124, by a stack of layers: a silicon substrate 216, a silicon oxide 214, a silicon device layer 212, and a dielectric bonding layer 210. The III-V structure 104 is formed, again from bottom to top with respect to the lamination direction 124, by a stack of layers: an n-type material 208 (with the grating 116 formed on or in a bottom surface thereof), the laser active region 202, and a p-type material 206.

The single-waveguide design 100 shown in FIG. 1 and FIG. 2 is thus formed from both silicon and a non-silicon material. In this example, the non-silicon material (alternatively referred to as "heterogeneous material") is a III-V material, but it will be appreciated that techniques and DFB laser architectures designs described herein are also applicable to devices in which the non-silicon heterogeneous material is a magneto-optic (MO) material or a crystal substrate material. III-V semiconductors have elements that are found in group III and group V of the periodic table (e.g., Indium Gallium Arsenide Phosphide (InGaAsP), Gallium Indium Arsenide Nitride (GaInAsN), Aluminum Indium Gallium Arsenide (AlInGaAs)). The carrier dispersion effects of III-V-based materials may be significantly higher than in silicon-based materials, as electron speed in III-V semiconductors is much faster than that in silicon. In addition, III-V materials have a direct bandgap, which enables efficient creation of light from electrical pumping. Thus, III-V semiconductor materials enable photonic operations with an increased efficiency over silicon for both generating light and modulating the refractive index of light. Thus, III-V semiconductor materials enable photonic operation with an increased efficiency at generating light from electricity and converting light back into electricity.

The low optical loss and high quality oxides of silicon are thus combined with the electro-optic efficiency of III-V semiconductors in some example heterogeneous optical devices described herein; in some examples, said heterogeneous devices utilize low loss heterogeneous optical waveguide transitions between the devices' heterogeneous and silicon-only waveguides.

Magneto-optical (MO) materials allow heterogeneous PICs to operate based on the MO effect. Such devices may utilize the Faraday Effect, in which the magnetic field associated with an electrical signal modulates an optical beam, offering high bandwidth modulation, and rotates the electric field of the optical mode, enabling optical isolators. Said MO materials may comprise, for example, materials such as iron, cobalt, or yttrium iron garnet (YIG). Further, in some example embodiments, crystal substrate materials provide heterogeneous PICs with a high electro-mechanical coupling, linear electro-optic coefficient, low transmission loss, and stable physical and chemical properties. Said crystal substrate materials may comprise, for example, lithium niobate (LiNbO3) or lithium tantalate (LiTaO3).

Formation of the silicon structure 102 and III-V structure 104, and their bonding together to fabricate the stacked single-waveguide design 100 shown in FIG. 2, are described below with reference to the method of FIG. 12.

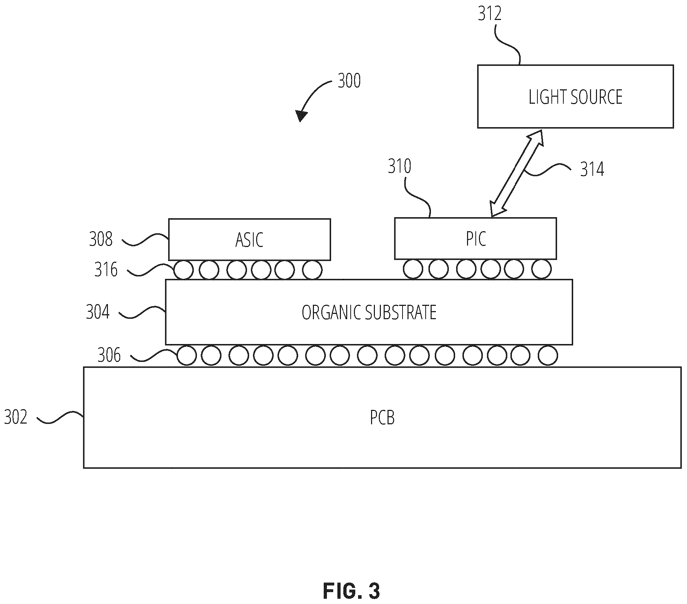

FIG. 3 illustrates a simplified side view of an example optical-electrical device 300 incorporating a DFB laser according to various examples described herein. In some examples, a DFB laser as described herein (e.g., a single-waveguide design 100, two-rib design 600, or narrow trench design 900 DFB laser) may be manufactured as, or as part of, a PIC 310. The PIC 310 may in turn be incorporated into an optical-electrical device 300 that may include other components, such as a printed circuit board (PCB) substrate (shown as PCB 302), an organic substrate 304 mounted to a top surface of the PCB 302, and an application-specific integrated circuit (ASIC 308) mounted to a top surface of the organic substrate 304. The PIC 310 incorporating the DFB laser may also be mounted to the top surface of the organic substrate 304 (where "top" may be defined with respect to the lamination direction 124).

In some examples, the PIC 310 (e.g., a DFB laser device according to the single-waveguide design 100 or other designs described herein) may exchange light with an external light source 312 via an optical fiber 314, in a flip-chip configuration where a top side of the PIC 310 is connected to the organic substrate 304 and light propagates out (or in) from a bottom side of the PIC 310 facing away from the organic substrate 304 (e.g., towards a coupler). The optical fiber 314 can couple with the PIC 310 using a prism, grating, or lens, according to some examples. The optical components of PIC 310 (e.g., optical modulators, optical switches) are controlled, at least in part, by control circuitry included in ASIC 308. Both ASIC 308 and PIC 310 are shown to be disposed on copper pillars 316, which are used for communicatively coupling the ASIC 308 and PIC 310 via organic substrate 304. PCB 302 is coupled to organic substrate 304 via a ball grid array (BGA) interconnect (BGA interconnect 306) and may be used to interconnect the organic substrate 304 (and thus, ASIC 308 and PIC 310) to other components of the optical-electrical device 300 not shown (e.g., interconnection modules, power supplies, etc.).

FIG. 4 illustrates a side view of the single-waveguide design 100 for a symmetric version of the DFB laser architecture of FIG. 1 showing symmetric light propagation during operation.

As shown in FIG. 4, the grating 116 is formed in the III-V structure 104 which is then then flipped and bonded to the silicon structure 102 (e.g., in a flip-chip configuration), in accordance with some examples. Further, a DFB electrode 408 applies current (e.g., forward bias) to generate the output light (e.g., single mode light from a QWS feature 128 in the grating 116, shown as DFB region light 402), and SOA electrodes 410 are configured to further amplify the light, which is then evanescently coupled (shown as outcoupled light 404) to the tapered portions of the silicon rib 110 of the silicon waveguide. The light may then propagate through the silicon waveguide and into other components of the device (e.g., PIC 310 or devices in optical communication therewith), shown as waveguide light 406. In some examples, the SOA electrodes 410 are partial electrodes or are omitted from the single-waveguide design 100.

Simulations of the outcoupling of light from the III-V structure 104 to the silicon structure 102 of the single-waveguide design 100 indicate that some versions of the single-waveguide design 100 may result in the generation of second-order or higher-order light. A version of the single-waveguide design 100 was simulated, using a light wavelength of 1310nm. The simulated single-waveguide design 100 had a III-V structure 104 with a ridge of p-type material 206 of 2.7um in width, a grating 116 of 17.5 nm in etch depth, and a silicon rib 110 of 0.3um in the narrow portion under the DFB region 114. (It will be appreciated that whereas in this simulated example, the wavelength is 1310nm, the single-waveguide design 100 and other designs described herein can be applied to any other wavelength of light.)

In the single-waveguide design 100, the fundamental mode of the output light generated by the laser active region, also referred to as the first lateral mode or the first-order lateral mode, was mainly confined in the DFB region 114 of the III-V structure 104 to obtain enough material gain to lase. A small portion of the fundamental mode light reached the grating 116 to achieve enough coupling and resonate along the longitudinal cavity of the DFB laser. The resonant wavelength of this light is defined by the grating pitch and the effective index of the mode.

This mode of light then coupled from the III-V structure 104 into the silicon waveguide via the tapered rib in the SOA region 112 near the end of the DFB cavity, which is designed (in this example) with a narrow operation window near 1310nm.

In this simulated example, the second-order transverse mode with two symmetric lobes may exist and resonate at 1300.5nm, which may be within the gain spectrum of the laser's epitaxially grown III-V material. Thus, this second-order mode of light may lase at 1300.5nm inside the III-V DFB region 114 confined by the grating 116. A fraction of this second-order mode can still out-couple into the silicon waveguide via the tapers of the silicon rib 110 in the SOA region 112, which were designed for coupling the fundamental mode at 1310nm wavelength light. The second-order light at the laser output leads to poor side-mode-suppression-ratio (SMSR), which is a significant performance impairment for single-mode optical data communication applications, where the laser is intended to be a single wavelength only. The second-order light also potentially causes laser efficiency degradation and/or reliability risk. Accordingly, it may be beneficial to provide alternative designs of the silicon structure 102 to prevent lasing of second-order and/or higher-order lateral modes of the output light.

One potential approach to achieving single-mode operation is to further narrow the width of the ridge of p-type material 206 along the lateral direction 122. According to simulation data, if the ridge of p-type material 206 is narrowed from 2.7um to 2.0um, the second transverse mode has a resonance wavelength at 1291.84nm, which is >15nm shorter than the fundamental mode, so the second-order light less chance to lase. If the width of the p-type material 206 is further reduce to 1.7um, the second transverse mode blueshifts 5nm more, making light of this mode unlikely to lase at high transmission. However, low transmission operation of the laser may still present a risk of second transverse mode light being generated. Furthermore, narrowing of the ridge of p-type material 206 may result in reliability and/or manufacturing challenges in the context of SOI DFB lasers.

Two other examples of designs for single transverse mode operation are described below with reference to the two-rib design 600 shown in FIG. 6 and the narrow trench design 900 shown in FIG. 9. In some examples, these further designs may provide further benefits over narrowing the width of the p-type material 206 ridge.

FIG. 5 illustrates a side view of an asymmetric version of the single-waveguide design 100 (asymmetric design 500), showing asymmetric light propagation during operation. In the illustrated example, the asymmetric design 500 includes only a single SOA region 112, and the grating 116 is configured with an asymmetric QWS feature 502 off-center in the DFB region 114, as described above.

FIG. 6 shows a top-down view of a two-rib design 600 for a DFB laser architecture. The two-rib design 600 may achieve single lateral mode operation for the DFB laser in some examples by suppressing the second-order lateral mode to prevent it from lasing.

The lateral direction 122 from FIG. 1 is shown here as first lateral direction 608, and its opposite direction is denoted as second lateral direction 610.

Whereas the first lateral mode of the output light is concentrated within the III-V structure 104 along the lateral centerline 614 of the DFB region 114, the second lateral mode of the output light is concentrated within the III-V structure 104 in two lateral lobes to the sides of the DFB region 114, shown as second mode lobes 804. The exact location of these second mode lobes 804 is typically a function of the dimensions of the III-V structure 104 and the wavelength of light generated by the laser active region 202.

Therefore, in order to minimize the generation of the second order lateral mode in the III-V structure 104, , the silicon structure 102 may include two laterally separated silicon portions located under (e.g., at least partially overlapping along the lamination direction 124) the locations of the second mode lobes 804, extending longitudinally (i.e., in or opposite the longitudinal direction 120). These laterally separated silicon portions may be effective to increase the mode confinement of the second lateral mode of the output light within the silicon structure 102, thereby decreasing the amount of the second lateral mode of the output light trapped within the III-V structure 104.

In the illustrated two-rib design 600, the two laterally separated silicon portions of the silicon structure 102 are formed as two parallel ribs 602 with a high refractive index, located directly under (with respect to lamination direction 124) the second mode lobes 804. These parallel ribs 602 function to couple the second lateral mode of the output light from the III-V structure 104 into the silicon structure 102, potentially reducing both optical modal gain (lower mode confinement in MQW) and grating efficiency. Therefore, the second lateral mode of the output light will be suppressed within the DFB region 114 of the III-V structure 104, experiencing lower modal gain due to being coupled away (e.g., opposite the lamination direction 124) from the laser active region 202. Furthermore, the second lateral mode of the output light will be less perturbed by the grating 116 and therefore experience weaker reflection along the grating 116, which prevent the III-V structure 104 from acting as a resonance cavity for the second lateral mode of the output light. These factors make the second-order mode unlikely to compete with the first-order mode of light and lase, and therefore the second-order mode may be effectively suppressed, making it less likely to cause laser efficiency degradation, reduced side-mode-suppression ratio, and/or reliability risk as described above.

In some examples, the lateral locations of the two parallel ribs 602 within the DFB region 114 are selected based on the wavelength of the output light and the dimensions of the device to be at or close to the centers of the second mode lobes 804. The parallel ribs 602 are separated laterally by a central trench 604, which may be filled with a gas or a dielectric material, as described above. Two lateral trenches 606 extend from the outer lateral sides of the parallel ribs 602 to at least the edges of the ridge of p-type material 206; these lateral trenches 606 may also be filled with a gas or dielectric material.

The SOA region 112 of the two-rib design 600 includes a tapered waveguide portion 612 similar to the silicon rib 110 of the single-waveguide design 100 within the taper region 118. However, in some examples of the two-rib design 600, the tapered waveguide portion 612 may taper continuously from the far longitudinal edge of the SOA region 112 to end at a near longitudinal edge. Furthermore, in some examples, the tapered waveguide portion 612 extends longitudinally out of the SOA region 112 into a portion of the DFB region 114, such that a portion of the tapered waveguide portion 612 overlaps with the grating 116, as shown in FIG. 6.

In a first example, the two-rib design 600 uses a ridge of p-type material 206 in the III-V structure 104 having a width of 2.7um, as described above with reference to the first simulated example single-waveguide design 100. Each parallel rib 602 within the DFB region 114 has a lateral width of 0.54um, and the lateral distance from each parallel rib 602 to the lateral edge of the ridge of p-type material 206, occupied by a lateral trench 606, is 0.06um. The central rib in each SOA region 112 has a lateral width of 2.0um at its widest point (at the far end of the SOA region 112 from the DFB region 114), tapering to a width of 0um where it ends 20um longitudinally within the DFB region 114. In simulation, this design has been demonstrated to suppress the second-order mode output light having a wavelength of 1310nm, such that confinement of the second lateral mode of the output light within the MQW forming the laser active region 202 is reduced to approximately 6%. Meanwhile, the first-order mode of the light maintains approximately 10% confinement in the MQW and stays lasing.

FIG. 7 illustrates a front cross-sectional view of the two-rib design 600 through line A-A of FIG. 6. The two symmetrical second mode lobes 804 are shown within the III-V structure 104, and the two parallel ribs 602 are located under the centerlines of these lobes. In operation, the parallel ribs 602 are effective to couple a high proportion of the second lateral mode of the output light downward (e.g., opposite the lamination direction 124) into the parallel ribs 602 of the silicon structure 102, thereby preventing this light from lasing within the DFB region 114 of the III-V structure 104. Thus, it will be appreciated that in at least some examples the two-rib design 600 is effective to shift the locations of the second mode lobes 804 downward at least partially into the parallel ribs 602; the second mode lobes 804 shown in FIG. 7 represent the locations of the second mode lobes 804 in the absence of this outcoupling effect.

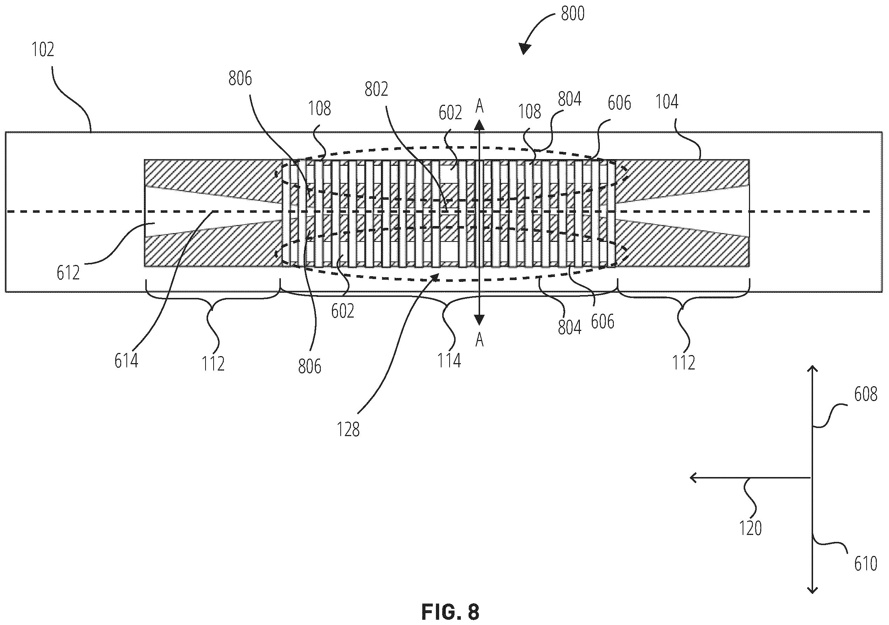

Additional designs for outcoupling the second lateral mode of the output light are described below with reference to FIG. 8 through FIG. 11.

FIG. 8 illustrates a top-down plan view of a three-rib design 800 for a DFB laser architecture. The three-rib design 800 varies the two-rib design 600 by adding a central third rib 802 down the lateral centerline 614 of the DFB region 114. The third rib 802 is thus contiguous with the tapered waveguide portion 612. In this respect, the three-rib design 800 resembles some aspects of the single-waveguide design 100, with the addition of the two parallel ribs 602 laterally separated from, and also parallel to, the third rib 802. The third rib 802 is laterally separated from the parallel ribs 602 by a pair of intermediate trenches 806, which may be filled with a gas or a dielectric material like the other trenches described herein.

In a first example, the three-rib design 800 has the same dimensions as the example two-rib design 600 described above, with the third rib 802 being 0.3um in lateral width.

FIG. 9 shows a top-down view of a narrow trench design 900 for a DFB laser architecture. Like the two-rib design 600 and three-rib design 800, the narrow trench design 900 may also achieve single lateral mode operation for the DFB laser in some examples by suppressing the second-order lateral mode to prevent it from lasing.

In the narrow trench design 900, the two laterally separated silicon portions within the DFB region 114 are formed as slabs 912 extending at least to the lateral sides of the ridge of p-type material 206. These slabs 912 are raised, like the parallel ribs 602 of the two-rib design 600 and the third rib 802 of the three-rib design 800, and are separated from each other by a trench. The slabs 912 may be effective to convert the well-confined second or higher order modes into lossy or leaky slab modes, preventing these modes from lasing. Instead of manifesting as a well-confined mode within the III-V structure 104, the second lateral mode of the output light may manifest as a leaky mode within the slabs 912 with a resonant tail penetrating into the silicon structure 102 without termination.

In the narrow trench design 900, the trench is a relatively narrow DFB trench 904 centered on the lateral centerline 614, such that the slabs 912 are located under the second mode lobes 804. In some examples of the narrow trench design 900, the DFB region 114 may be regarded as extending the longitudinal length of the grating 116, and the SOA regions 112 may be regarded as the remaining longitudinal portions of the III-V structure 104. In some examples, the DFB trench 904 does not extend the full length of the grating 116; instead, the longitudinal span of the DFB trench 904 may be referred to as a narrow trench absorber region 906, bounded along the longitudinal direction 120 on both sides by two non-absorber regions 908 that largely overlap the SOA regions 112.

The non-absorber regions 908 each include further portions of the slabs 912, tapering toward the outer lateral edges of the III-V structure 104 for at least a part of their length. These portions of the slabs 912 define outer lateral edges of two SOA trenches 902. Between the two SOA trenches 902 is a tapered waveguide portion 910 extending longitudinally along the lateral centerline 614 and tapering within a taper region 118 to narrow in proximity to the DFB region 114 and widen in proximity to the outer longitudinal ends of the SOA regions 112, similar to the silicon rib 110 of the single-waveguide design 100.

As with the tapered waveguide portion 612 of the two-rib design 600 and three-rib design 800, the tapered waveguide portion 910 may extend into the DFB region 114 such that it overlaps with a portion of the grating 116. The longitudinal span of the tapered waveguide portion 910 may be regarded as defining the non-absorber region 908; the longitudinal position where the tapered waveguide portion 910 ends (e.g., tapers to zero width) and the DFB trench 904 begins can be regarded as the end of the non-absorber region 908 and the beginning of the narrow trench absorber region 906.

In some examples, the two SOA trenches 902 are contiguous with the DFB trench 904. The inward widening of the portions of the slabs 912, and the inward tapering of the tapered waveguide portion 910, may be such that the SOA trenches 902 each taper to a narrower portion overlapping with the grating 116. These narrower portions of the SOA trenches 902 connect with the DFB trench 904.

The illustrated example narrow trench design 900 has a central DFB trench 904. However, in some examples, the waveguide of the narrow trench design 900 may include a further narrow rib (not shown) running down the lateral centerline 614 in the middle of the DFB trench 904 and contiguous with the tapered waveguide portion 910, similar to silicon rib 110 of the single-waveguide design 100 or the third rib 802 of the three-rib design 800.

In a first example, the narrow trench design 900 has a DFB trench 904 with a lateral width of 1.7um. The tapered waveguide portion 910 in each SOA region 112 has a lateral width of 2.0um at its widest point (at the far end of the SOA region 112 from the DFB region 114), tapering to a width of 0um where it ends at a length of 20um longitudinally underneath the grating 116. The two SOA trenches 902 are each 1.75um wide at the far end of the SOA region 112 from the DFB region 114.

In simulation, this design has been demonstrated to increase the mode loss of second-order mode output light having a wavelength of 1310nm, with simulated widths of the DFB trench 904 ranging from approximately 1.5um to 2um resulting in mode loss ratios of the first order mode to second order mode ranging from approximately 2 to 3.

In some examples, the narrow trench design 900 may exhibit various trade-offs relative to the two-rib design 600 and/or three-rib design 800. In some cases, the mode loss ratio of the narrow trench design 900 may not be as favorable as that of the two-rib design 600 or three-rib design 800; however, the narrow trench design 900 may use more silicon in the silicon structure 102 (due to the relatively large size of the slabs 912), resulting in improved thermal performance.

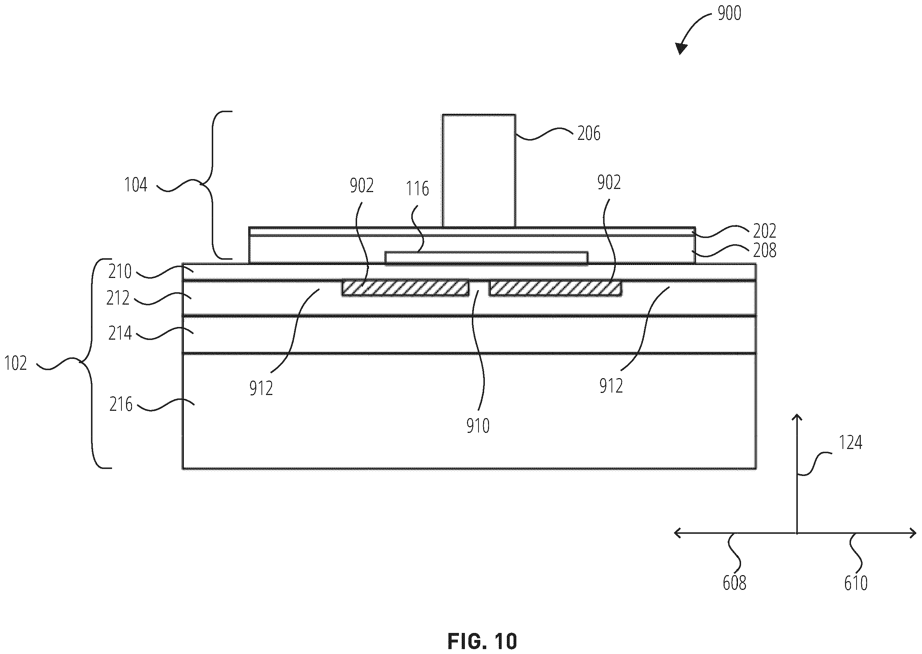

FIG. 10 illustrates a front cross-sectional view of the non-absorber region 908 of the narrow trench design 900 through line A-A of FIG. 9. This figure shows the two SOA trenches 902, the tapered waveguide portion 910, and the further portions of the slabs 912 within the non-absorber region 908.

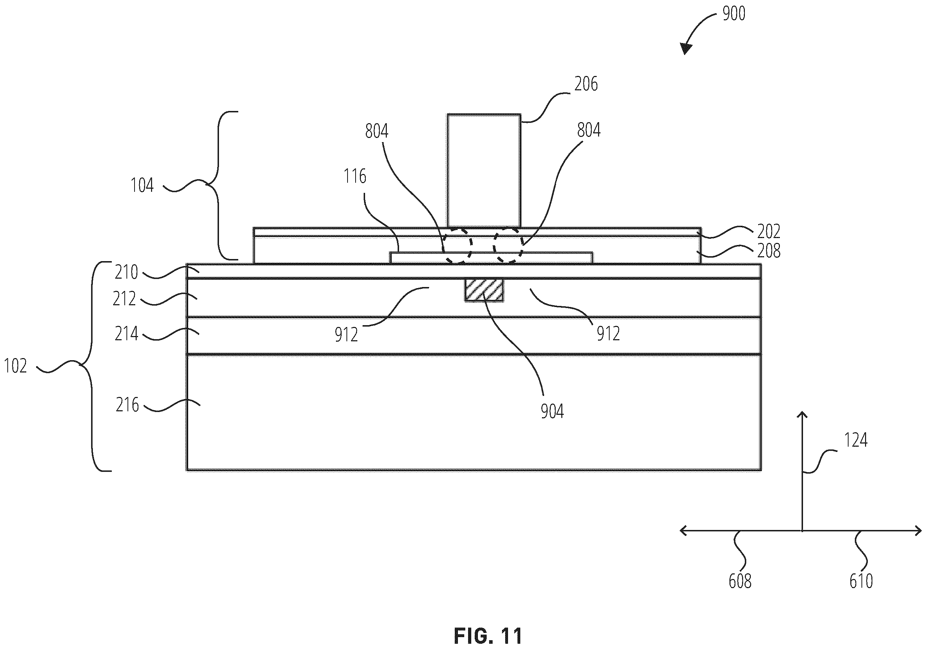

FIG. 11 illustrates a front cross-sectional view of the narrow trench absorber region 906 of the narrow trench design 900 through line B-B of FIG. 9. This figure shows the DFB trench 904 situated between the two slabs 912. A center-most portion of each slab 912 is located underneath a center of a respective second mode lobe 804 in the III-V structure 104; the slabs each extend laterally from the center-most position underneath a center of a respective second mode lobe 804 to a lateral position at a far lateral edge (left or right edge in FIG. 11) of the structure. As in FIG. 7, the locations of the second mode lobes 804 shown in the drawing represent the locations of the second mode lobes 804 in the absence of the outcoupling effect of the slabs 912: in at least some examples, the second mode does not manifest at all, but is instead replaced by a lossy or leaky slab mode located at least partially within the slabs 912.

FIG. 12 shows operations of a method 1200 of manufacturing a DFB laser having a single lateral mode, such as a single lateral mode DFB laser according to the two-rib design 600 or narrow trench design 900. Although the example method 1200 depicts a particular sequence of operations, the sequence may be altered without departing from the scope of the present disclosure. For example, some of the operations depicted may be performed in parallel or in a different sequence that does not materially affect the function of the method 1200. In other examples, different components of an example device or system that implements the method 1200 may perform functions at substantially the same time or in a specific sequence.

According to some examples, the method 1200 includes forming a III-V semiconductor structure (e.g., III-V structure 104) by growth at operation 1202. For example, a III-V wafer comprising one or more layers of InP, GaAs, AlAs, or InAs is partially grown (e.g., grown using III-V epitaxy growth manufacturing processing) to form the p-type material 206, laser active region 202, and n-type material 208.

According to some examples, the method 1200 includes etching the grating 116 in the III-V structure 104 at operation 1204. For example, the DFB region 114 grating 116 is then patterned on the III-V structure (e.g., on a top surface of the n-type material 208 using nano-imprint or electron-beam lithography, including wet and/or dry etching).

According to some examples, the method 1200 includes further forming the III-V structure 104 by regrowth at operation 1206. In some examples, after the DFB grating 116 is patterned on the III-V structure 104 (e.g., wet and/or dry etched), additional layers of the III-V material are grown to on the etchings. In other examples, the grating 116 is a top-surface grating and no further regrowth over the grating 116 occurs; instead, the bonding surface of the top-surface grating is bonded to the silicon wafer (e.g., silicon structure 102), as discussed in further detail below.

According to some examples, the method 1200 includes filling the teeth (e.g., grating lines 108) of the grating 116 at operation 1208. In some example embodiments, prior to bonding, a dielectric bonding layer 210 (e.g., SiO2, SiN, or Al2O3) is added to the surface of the etched III-V structure 104 to improve bonding.

According to some examples, the method 1200 includes bonding the III-V structure 104 to the silicon structure 102 at operation 1210. In some example embodiments, the etched III-V structure 104 is bonded to the silicon structure 102 using plasma enhanced wafer bonding. For example, (1) a III-V epitaxial wafer is patterned with one or more the DFB gratings 116 and alignment marks to align the III-V structure 104 on the silicon wafer; (2) the III-V epitaxial wafer is mounted face down on UV release tape and the singulation process is performed on the backside of the III-V epitaxial wafer to protect the frontside surface (e.g., top-surface grating, bonding side) from damage and contamination; and (3) each III-V epitaxial die is accurately bonded to a target SOI using the alignment marks such that the grating and laser active region 202 are disposed over (e.g., overlapping in the lamination direction) the narrow width of the silicon waveguide and the tapers of the silicon waveguide are disposed under respective SOA regions of the III-V die.

In some examples, the etched III-V structure 104 is bonded to the silicon structure 102 using micro-Transfer Printing (uTP). For example, (1) a III-V epitaxial wafer is patterned with DFB gratings and alignment marks to align the III-V epitaxial structure on the silicon; (2) the III-V epitaxial wafer is singulated into III-V epitaxial dies using uTP process of etching and undercutting; and (3) each III-V epitaxial die is accurately bonded to a target SOI using the uTP stamp process.

In some examples, the etched III-V structure 104 is then cleaved into small rectangles (e.g., epitaxial dies) using the alignment marks on the etched III-V structure 104 to align cleave locations to the gratings. The etched III-V structure 104 (e.g., an epitaxial die) is then bonded to the SOI structure to form the bonded structure (e.g., multiple III-V structures 104 bonded to multiple silicon structures 102). In some examples, the bonded structure is then further processed to form additional circuit components, and vias and metallic pads are integrated into the bonded structure to provide current and drive the DFB laser.

As described above, while DFB lasers can have gratings fabricated in the silicon waveguide, the fabrication process uses specialized lithography equipment to generate a grating pattern with sufficiently small dimensions. Unfortunately, silicon foundries may not have lithography capabilities for grating fabrication and generally it requires heavy capital investment in further equipment (e.g., deep UV lithography equipment). Further, development time of the Si grating process can be significant, and the poor repeatability of the process is still problematic. Further, moving production wafers out of the Si foundry to perform the grating step elsewhere increases cycle time and risks contamination.

Thus, in some examples described herein, the grating 116 is formed in the III-V structure 104 using III-V epitaxy growth, and optionally regrowth. In some example embodiments, the III-V epitaxial structure is first half-way grown (at operation 1202), then the grating 116 is patterned and etched (at operation 1204), and the laser structure is finished by regrowth (at operation 1206) to embed the grating inside the materials. In some example embodiments, the III-V layers are grown to specification and a top-surface grating 116 is etched and no regrowth occurs (e.g., the III-V epi die is flip-chip bonded to the SOI using the top-surface such that the mode is adiabatically coupled to the silicon waveguides in the SOI), thereby omitting operation 1206. One advantage of forming a DFB grating 116 in the III-V structure 104 is that it parallelizes manufacturing processes between the foundries: for example, between a III-V manufacturing facility that produces the III-V grating structure in parallel with a silicon wafer manufacturing facility to completes the silicon wafer front end processing. Further, a DFB laser with the grating in the III-V structure avoids extra process steps in the silicon foundry beyond the existing silicon photonics (SiPh) process flow (e.g., used to design the silicon wafer). In this way, many Si foundries can more readily be used to manufacture a DFB laser with wafer bonding processes. For instance, a given SiPh foundry may be configured for 500nm silicon thickness in the SOI wafer, while other SiPh foundries may be configured for a 220nm silicon thickness; however, it can be difficult or not possible to form gratings in the silicon wafer when the silicon is as thin as 220nm. As such, forming the grating 116 in the III-V structure 104 may enable the design and fabrication processes to become insensitive to SOI thickness, which allows implementation of examples described herein to various SOI structures including 220nm Si.

Whereas examples have been described as providing a DFB laser formed in a III-V semiconductor layer of a PIC, it will be appreciated that the techniques and designs described herein may be applicable to achieving a single lateral mode in various types of heterogeneously integrated laser, such as a DFB laser, a discrete mode (DM) laser, a distributed Bragg reflector (DBR) laser, an optical amplifier, an optical modulator, or a tunable laser which requires single mode control along a lateral direction. The described designs may be applied to a waveguide and silicon structure of an optical device that functions to outcouple second-order mode light from various laser structures or other light sources. Thus, in some examples, a device may be provided that includes a silicon structure having a silicon waveguide configured to receive light from a first end of an active region of a light source. The active region of the light source is in contact with a surface of the silicon structure in a lamination direction. The silicon structure includes a DFB region overlapping at least a portion of the active region with respect to the lamination direction. The DFB region includes surfaces of the silicon structure defining at least two laterally separated silicon portions extending in a longitudinal direction perpendicular to the lamination direction and overlapping, with respect to the lamination direction, two lobes of a second lateral mode of the light in the active region. In some examples, the silicon structure also includes a SOA region displaced from the DFB region in the longitudinal direction. The SOA region includes surfaces of the silicon waveguide defining a tapered waveguide portion increasing in a lateral width in the longitudinal direction.

As will be appreciated, the processing operations described here may be carried out under computer control for the processing stages outlined with respect to Figure 12 above. Such computer control may rely upon program instructions executable to 0put such a control approach into practice. Such instructions may be provided to a processor of a control apparatus by way of a computer-readable medium. A computer readable medium may be provided by way of a computer-readable storage medium and/or a computer-readable transmission medium. A computer-readable storage medium, which may be referred to as a non-transitory computer-readable medium, stores instructions for use by a processor. Examples of a computer-readable storage medium may include a CD, a DVD, a storage device, a diskette, a tape, flash memory, physical memory, or any other computer-readable storage medium. As noted above, a computer-readable medium may also or alternatively be a transmission medium by which instructions may be conveyed. A computer-readable transmission medium may include carrier waves, transmission signals or the like. A computer-readable transmission medium may convey instructions between components of a single computer system and/or between plural separate computer systems.

Other examples of such an optical device may include features, and combinations or subcombinations of features, of the various examples described herein.

In view of the disclosure above, various examples are set forth below. It should be noted that one or more features of an example, taken in isolation or combination, should be considered within the disclosure of this application.

Therefore, from one perspective, there has been described a DFB laser that includes a III-V semiconductor structure having a laser active region and a grating etched on a bonding surface to provide optical feedback to generate output light. The DFB laser includes a silicon structure having a silicon waveguide configured to receive the output light from a first end of the laser active region. The bonding surface of the III-V semiconductor structure is bonded to a surface of the silicon structure. The silicon structure includes a DFB region having surfaces defining at least two laterally separated silicon portions extending longitudinally and overlapping, with respect to a lamination direction, two lobes of a second lateral mode of the output light in the laser active region, to suppress lasing of a second order mode of the output light.

The following are example embodiments:
Example 1 is a distributed feedback (DFB) laser comprising: a III-V semiconductor structure comprising: a laser active region having a first end and a second end displaced from the first end in a longitudinal direction; and a grating etched on a bonding surface of the III-V semiconductor structure to provide optical feedback to the laser active region to generate output light that is output from the laser active region; and a silicon structure comprising a silicon waveguide configured to receive the output light from the first end of the laser active region, the III-V semiconductor structure bonded to the silicon structure such that the bonding surface is bonded to a surface of the silicon structure, the silicon structure further comprising: a DFB region comprising surfaces of the silicon structure defining at least two laterally separated silicon portions extending in the longitudinal direction and overlapping, with respect to a lamination direction perpendicular to the longitudinal direction, two lobes of a second lateral mode of the output light in the laser active region.
In Example 2, the subject matter of Example 1 includes, wherein the silicon structure further comprises: a semiconductor optical amplifier (SOA) region, displaced from the DFB region in the longitudinal direction, the SOA region comprising surfaces of the silicon waveguide defining a tapered waveguide portion increasing in a lateral width in the longitudinal direction.
In Example 3, the subject matter of Example 2 includes, wherein: the DFB laser is a symmetric DFB laser; the laser active region is configured to output the output light from the first end and the second end; and the silicon waveguide is configured to receive the output light from the first end and the second end of the laser active region.
In Example 4, the subject matter of Example 3 includes, wherein: the silicon structure further comprises a second SOA region, displaced from the DFB region in a direction opposite the longitudinal direction, the second SOA region comprising surfaces of the silicon waveguide defining a second tapered waveguide portion decreasing in a lateral width in the longitudinal direction.
In Example 5, the subject matter of Examples 1-4 includes, wherein: the at least two laterally separated silicon portions are laterally separated by at least one trench filled with a gas.
In Example 6, the subject matter of Examples 1-5 includes, wherein: the at least two laterally separated silicon portions are laterally separated by at least one trench filled with a dielectric material.
In Example 7, the subject matter of Examples 2-6 includes, wherein: the tapered waveguide portion extends longitudinally into a portion of the DFB region.
In Example 8, the subject matter of Example 7 includes, wherein: the at least two laterally separated silicon portions comprises two parallel ribs.
In Example 9, the subject matter of Example 8 includes, wherein: the silicon structure further comprises a third rib parallel to and between the two parallel ribs within the DFB region, the third rib being contiguous with the tapered waveguide portion.
In Example 10, the subject matter of Examples 2-9 includes, wherein: the at least two laterally separated silicon portions comprises two silicon slabs separated by a narrow trench, the narrow trench having a lateral width narrower than either of the silicon slabs.
In Example 11, the subject matter of Example 10 includes, wherein: the grating overlaps at least a portion of the tapered waveguide portion with respect to the lamination direction.
In Example 12, the subject matter of Examples 10-11 includes, wherein: the SOA region further comprises surfaces of the silicon structure defining two further portions of the silicon slabs separated laterally from the tapered waveguide portion by two tapered trenches increasing in a lateral width in the longitudinal direction, the two tapered trenches being contiguous with the narrow trench of the DFB region.
Example 13 is a device comprising: a silicon structure comprising a silicon waveguide configured to receive light from a first end of an active region of a light source, the active region of the light source being in contact with a surface of the silicon structure in a lamination direction; the silicon structure further comprising: a distributed feedback (DFB) region comprising surfaces of the silicon structure defining at least two laterally separated silicon portions extending in a longitudinal direction perpendicular to the lamination direction and overlapping, with respect to the lamination direction, two lobes of a second lateral mode of the light in the active region.
In Example 14, the subject matter of Example 13 includes, wherein the silicon structure further comprises: a semiconductor optical amplifier (SOA) region, displaced from the DFB region in the longitudinal direction, the SOA region comprising surfaces of the silicon waveguide defining a tapered waveguide portion increasing in a lateral width in the longitudinal direction.
In Example 15, the subject matter of Example 14 includes, wherein: the tapered waveguide portion extends longitudinally into a portion of the DFB region.
In Example 16, the subject matter of Example 15 includes, wherein: the at least two laterally separated silicon portions comprises two parallel ribs.
In Example 17, the subject matter of Example 16 includes, wherein: the silicon structure further comprises a third rib parallel to and between the two parallel ribs within the DFB region, the third rib being contiguous with the tapered waveguide portion.
In Example 18, the subject matter of Examples 14-17 includes, wherein: the at least two laterally separated silicon portions comprises two silicon slabs separated by a narrow trench, the narrow trench having a lateral width narrower than either of the silicon slabs.
In Example 19, the subject matter of Example 18 includes, wherein: the tapered waveguide portion overlaps at least a portion of the active region with respect to the lamination direction.
Example 20 is a method of manufacturing a distributed feedback (DFB) laser, comprising: etching a grating on a III-V semiconductor structure, the III-V semiconductor structure comprising a laser active region configured to generate light, the grating being etched on a bonding surface of the III-V semiconductor structure to provide optical feedback to the laser active region to generate output light that is output from a first end of the active region and that is further output from a second end of the active region displaced from the first end in a longitudinal direction; and bonding the III-V semiconductor structure to a silicon structure, the silicon structure comprising a silicon waveguide configured to receive the output light from the first end of the laser active region, the III-V semiconductor structure bonded to the silicon structure such that the bonding surface is bonded to a surface of the silicon structure, the silicon structure further comprising: a DFB region comprising surfaces of the silicon structure defining at least two laterally separated silicon portions extending in the longitudinal direction and overlapping, with respect to a lamination direction perpendicular to the longitudinal direction, two lobes of a second lateral mode of the output light in the laser active region.
Example 21 is at least one machine-readable medium including instructions that, when executed by processing circuitry, cause the processing circuitry to perform operations to implement of any of Examples 1-20.
Example 22 is an apparatus comprising means to implement of any of Examples 1-20.
Example 23 is a system to implement of any of Examples 1-20.
Example 24 is a method to implement of any of Examples 1-20.

## Claims

1. A device comprising:
a silicon structure comprising a silicon waveguide configured to receive light from a first end of an active region of a light source, the active region of the light source being in contact with a surface of the silicon structure in a lamination direction;
the silicon structure further comprising:
a distributed feedback, DFB, region comprising surfaces of the silicon structure defining at least two laterally separated silicon portions extending in a longitudinal direction perpendicular to the lamination direction and overlapping, with respect to the lamination direction, two lobes of a second lateral mode of the light in the active region.

2. The device of claim 1, wherein the silicon structure further comprises:
a semiconductor optical amplifier (SOA) region, displaced from the DFB region in the longitudinal direction, the SOA region comprising surfaces of the silicon waveguide defining a tapered waveguide portion increasing in a lateral width in the longitudinal direction.

3. The device of claim 2, wherein:
the tapered waveguide portion extends longitudinally into a portion of the DFB region.

4. The device of claim 3, wherein:
the at least two laterally separated silicon portions comprises two parallel ribs.

5. The device of claim 4, wherein:
the silicon structure further comprises a third rib parallel to and between the two parallel ribs within the DFB region, the third rib being contiguous with the tapered waveguide portion.

6. The device of claim 2 or 3, wherein:
the at least two laterally separated silicon portions comprises two silicon slabs separated by a narrow trench, the narrow trench having a lateral width narrower than either of the silicon slabs.

7. The device of claim 6, wherein:
the tapered waveguide portion overlaps at least a portion of the active region with respect to the lamination direction.

8. A distributed feedback (DFB) laser comprising:
a III-V semiconductor structure comprising:
a laser active region having a first end and a second end displaced from the first end in a longitudinal direction; and
a grating etched on a bonding surface of the III-V semiconductor structure to provide optical feedback to the laser active region to generate output light that is output from the laser active region; and
the silicon structure of any preceding claim, wherein the silicon waveguide is configured to receive the output light from the first end of the laser active region, and the III-V semiconductor structure is bonded to the silicon structure such that the bonding surface is bonded to a surface of the silicon structure.

9. The DFB laser of claim 8, when dependent at least from claim 2, wherein:
the DFB laser is a symmetric DFB laser;
the laser active region is configured to output the output light from the first end and the second end; and
the silicon waveguide is configured to receive the output light from the first end and the second end of the laser active region.

10. The DFB laser of claim 9, wherein:
the silicon structure further comprises a second SOA region, displaced from the DFB region in a direction opposite the longitudinal direction, the second SOA region comprising surfaces of the silicon waveguide defining a second tapered waveguide portion decreasing in a lateral width in the longitudinal direction.

11. The DFB laser of any of claims 8 to 10, wherein:
the at least two laterally separated silicon portions are laterally separated by at least one trench filled with one or more selected from the group comprising: a gas; and a dielectric material.

12. The DFB laser of any of claims 8 to 10, when dependent at least from claim 6, wherein:
the SOA region further comprises surfaces of the silicon structure defining two further portions of the silicon slabs separated laterally from the tapered waveguide portion by two tapered trenches increasing in a lateral width in the longitudinal direction,
the two tapered trenches being contiguous with the narrow trench of the DFB region.

13. A method of manufacturing a distributed feedback, DFB, laser, comprising:
etching a grating on a III-V semiconductor structure, the III-V semiconductor structure comprising a laser active region configured to generate light, the grating being etched on a bonding surface of the III-V semiconductor structure to provide optical feedback to the laser active region to generate output light that is output from a first end of the active region and that is further output from a second end of the active region displaced from the first end in a longitudinal direction; and
bonding the III-V semiconductor structure to a silicon structure, the silicon structure comprising a silicon waveguide configured to receive the output light from the first end of the laser active region, the III-V semiconductor structure bonded to the silicon structure such that the bonding surface is bonded to a surface of the silicon structure,
the silicon structure further comprising:
a DFB region comprising surfaces of the silicon structure defining at least two laterally separated silicon portions extending in the longitudinal direction and overlapping, with respect to a lamination direction perpendicular to the longitudinal direction, two lobes of a second lateral mode of the output light in the laser active region.

14. The method of claim 13, further comprising forming the structures as defined in any of claims 2 to 12.

15. A computer-readable medium comprising instructions that, when executed by one or programmable processors, cause one or more programmable processors to become configured to control the method of claim 13 or 14.
